Europäisches Patentamt

European Patent Office

Office européen des brevets

(11) Publication number: **0 189 970**

**A1**

## EUROPEAN PATENT APPLICATION

(21) Application number: 86300067.5

(22) Date of filing: 07.01.86

(51) Int. Cl.⁴: **H 01 F 7/22**

(30) Priority: 07.01.85 JP 242/85

(43) Date of publication of application:
06.08.86 Bulletin 86/32

(84) Designated Contracting States:
DE GB NL

(71) Applicant: MITSUBISHI DENKI KABUSHIKI KAISHA
2-3, Marunouchi 2-chome Chiyoda-ku
Tokyo 100(JP)

(72) Inventor: Saitou, Yoshio c/o Ako Works
Misubishi Denki KK 651, Tenwa
Ako City Hyogo Prefecture(JP)

(72) Inventor: Kataoka, Takeshi c/o Ako Works
Misubishi Denki KK 651, Tenwa
Ako City Hyogo Prefecture(JP)

(72) Inventor: Takechi, Moriaki c/o Ako Works
Misubishi Denki KK 651, Tenwa
Ako City Hyogo Prefecture(JP)

(72) Inventor: Matsumoto, Takahiro c/o Ako Works
Misubishi Denki KK 651, Tenwa
Ako City Hyogo Prefecture(JP)

(74) Representative: Lawson, David Glynne et al,
MARKS & CLERK 57-60 Lincoln's Inn Fields
London WC2A 3LS(GB)

(54) Superconductor magnet.

(57) A superconducting magnet comprises a superconducting coil (4) which generates a magnetic field when current is caused to flow therethrough, and a vacuum heat insulation vessel (6) which serves to receive the coil and to hold it at a cyrogenic temperature, and said vacuum heat insulation vessel has a part thereof e.g. the outer cylinder (7) made of a ferromagnetic material which has a size and a thickness sufficient to exhibit a magnetic shield effect.

FIG. I

799 P 51515

4

## SUPERCONDUCTING MAGNET

Background of the Invention :

This invention relates to a superconducting magnet, and more particularly to a vacuum heat insulation vessel which receives the superconducting coil of a superconducting magnet.

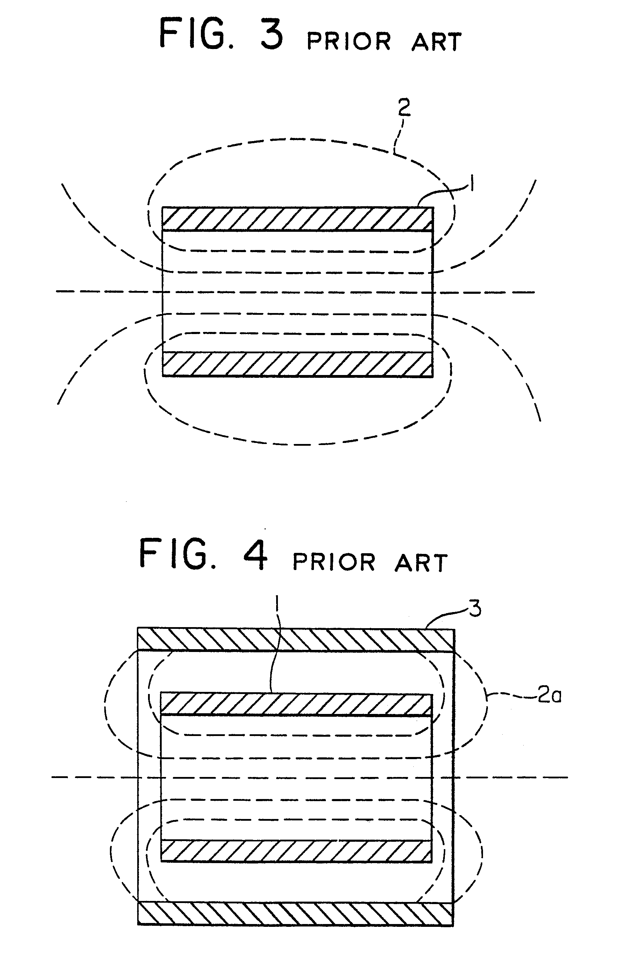

Fig. 3 shows a sectional view of a prior-art magnet. In Fig. 3, numeral 1 designates a coil which generates a magnetic field 2 when a current flows through the winding thereof. In general, a magnet whose coil is small generates a weak magnetic field and is often used without providing a magnetic shield as shown in Fig. 3, since the magnetic field exerts little influence on the surroundings. Fig. 4 shows a sectional view of another example. In Fig. 4, numeral 1 designates a coil by which magnetic fluxes 2a are generated. Numeral 3 designates a magnetic shield which is made of a ferromagnetic substance.

As shown in Fig. 4, in a case where the coil has a large geometry or establishes an intense magnetic field, the magnetic shield made of the ferromagnetic substance is employed for the purpose of preventing the influence of the magnetic field on the surroundings (for example, influence on a magnetic disc for a computer installed nearby).

2

The prior-art magnets are constructed as shown in Figs. 3 and 4. In the magnet of Fig. 3, the magnetic fluxes 2 interlinking with the coil 1 are generated by energizing the coil. Most of the magnetic fluxes 2 extend along the inner periphery of the coil 1, and some of them traverse the coil 1, to pass through the interior of the coil 1, whereupon the magnetic fluxes 2 extend outside the outer periphery of the coil 1 and enter the interior of the coil 1. Thus, the magnetic fluxes depict loops. On this occasion, the magnetic fluxes extending outside the outer periphery of the coil 1 spread spaciously, and a region which has an intense magnetic field becomes large. Accordingly, when the magnetic disc device or the like of a computer or the like, which is susceptible to a magnetic field, is located in the vicinity of this intense magnetic field, it malfunction may arise.

In the magnet of Fig. 4, the magnetic fluxes 2a interlinking with the coil are generated by energizing the coil 1 as in the case of Fig. 3. In this magnet, since the magnetic shield 3 made of the ferromagnetic substance of high permeability is disposed outside the outer periphery of the coil 1 as shown in Fig. 4, most of the magnetic fluxes 2a generated by the coil 1 are contained inside the magnetic shield 3, and the magnetic fluxes which pass outside the magnetic shield 3 lessen to narrow the region having an intense magnetic field. Accordingly, even when equipment liable to be influenced by a magnetic field is installed near the magnet, it is not influenced thereby.

In this regard, a superconducting magnet is received in a vacuum heat insulation vessel. Therefore, when the magnetic shield of the type described above is applied to the superconducting magnet, it needs to be disposed around the outer periphery of the vacuum heat insulation vessel, resulting in the problem that the geometry of the superconducting magnet enlarges. Another problem is that the double vessel structure consisting of the magnetic shield and the vacuum heat insulation vessel is uneconomical.

Summary of the Invention:

This invention has been made in view of the problems as described above, and has for its object to provide a superconducting magnet which can be constructed economically and in a small size.

A superconducting magnet according to this invention is characterized in that a part, principally the outer peripheral part, of a vacuum heat insulation vessel which serves to receive a superconducting coil therein and to hold it at a cryogenic temperature is made of a ferromagnetic material, for example, iron which is thick enough to have a magnetic shield effect.

4

have a magnetic shield effect.

Since the vacuum heat insulation vessel is made of the ferromagnetic material having the magnetic shield effect, it can execute simultaneously with a heat insulating action, the function of magnetically shielding a magnetic field which is generated when a current to flows through the superconducting coil.

Brief Description of the Drawings:

Fig. 1 is a sectional view showing an embodiment of a superconducting magnet according to this invention;

Fig. 2 is a sectional view showing another embodiment;

Fig. 3 is a sectional view showing an example of a prior-art magnet; and

Fig. 4 is a sectional view of another prior-art magnet which is furnished with a magnetic shield.

In the drawings, the same symbols indicate identical or corresponding portions.

Description of the Preferred Embodiments:

Now, this invention will be described in detail in connection with illustrated embodiments.

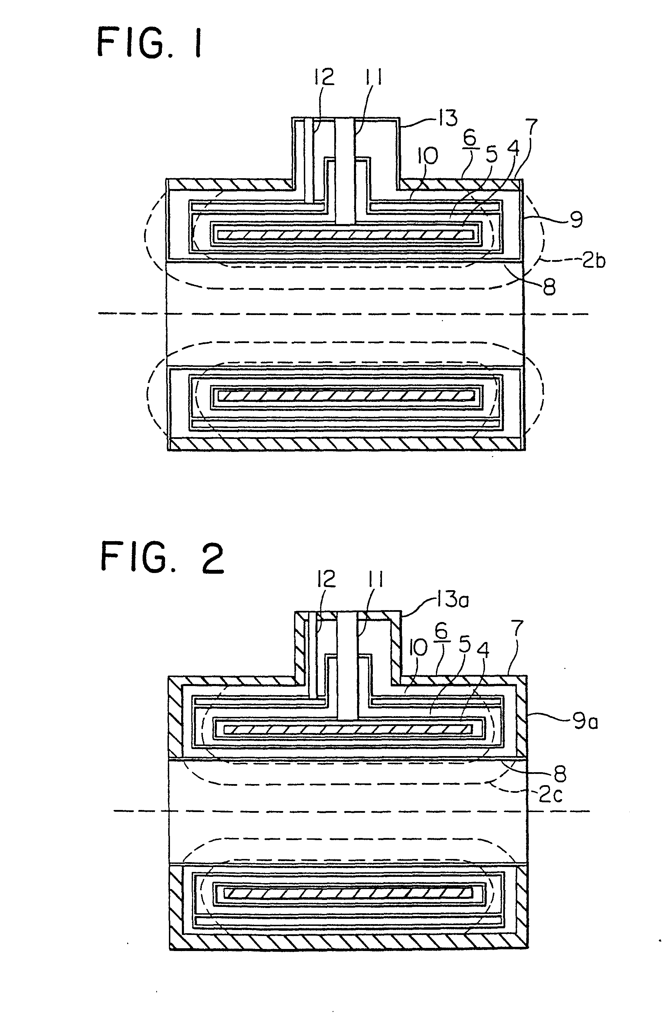

Referring to Fig. 1, numeral 4 designates a superconducting coil which is constructed by winding a superconducting wire. A liquid helium tank 5 receives the superconducting coil 4, and contains a cryogen such as liquid helium for cooling the superconducting coil 4. Numeral 6 generally designates a vacuum heat insulation vessel which receives the liquid helium tank 5, and has its interior evacuated for heat insulation.

An outer cylinder 7 lies at the outer peripheral part of the vacuum heat insulation vessel 6 and is made of a ferromagnetic material of high permeability having a thickness sufficient to exhibit a magnetic shield effect. An inner cylinder 8 forms the inner periphery of the vacuum heat insulation vessel 6. Flanges 9 correspond to the end parts of the vacuum heat insulation vessel 6. Shown at numeral 10 is a thermal shield which lies between the liquid helium tank 5 and the vacuum heat insulation vessel 6, and which surrounds the liquid helium tank 5. This thermal shield 10 is mounted for the purpose of reducing the quantity of heat to enter the liquid helium tank 5, and it is cooled by liquid nitrogen. A communication pipe 11 holds the liquid helium tank 5 and the exterior of the vessel 6 in communication, while a communication pipe 12 holds the thermal shield 10 and the exterior of the vessel 6 in communication. In order to lengthen the communication pipes and to set sufficient heat insulation distances, a projection 13 is provided. Magnetic fluxes 2b are generated by the superconducting coil 4.

6

In the superconducting magnet constructed as shown in Fig. 1, the magnetic fluxes 2b are generated so as to interlink with the superconducting coil 4 when conducting current through this coil. Most of the magnetic fluxes 2b extend along the inner periphery of the superconducting coil 4, and some of them traverse the superconducting coil 4, whereupon they extend along the outer periphery of the superconducting coil 4. Outside the outer periphery of the superconducting coil 4, most of the magnetic fluxes pass through the outer cylinder 7 of the vacuum heat insulation vessel 6 having the function of the magnetic shield, and they return inside the superconducting coil 4. Thus, the magnetic fluxes 2b form loops.

Accordingly, the magnetic fluxes generated by the superconducting coil 4 do not spread much beyond the outer periphery of the outer cylinder 7, whereby the intensity of the magnetic field outside the outer periphery of the superconducting magnet can be suppressed. At the same time, the vacuum heat insulation vessel 6 required in a superconducting magnet is formed.

While the above embodiment has been illustrated as to the case where only the outer cylinder 7 of the vacuum heat insulation vessel 6 is made of the ferromagnetic substance, similar effects are produced when flanges

9a and a projection 13a are also made of the ferromagnetic substance as shown in Fig. 2. In Fig. 2, symbol 2c denotes magnetic fluxes generated by the superconducting coil 4. Since the other portions are identical or equivalent to those in Fig. 1, the description thereof will be omitted.

In addition, when the superconducting coil 4 is arranged concentrically with the outer cylinder 7 and flanges 9a of the vacuum heat insulation vessel 6, the magnetic shield is endowed with a symmetry to the magnetic field inside the superconducting coil 4. Accordingly, no influences on the magnetic field inside the superconducting coil 4 occur, and influences thereon are low in case a high degree of uniformity in the magnetic field inside the superconducting coil 4 is required.

As described above, according to this invention, the vacuum heat insulation vessel of a superconducting magnet has a part thereof, principally its outer cylinder, made of a ferromagnetic substance having a magnetic shield effect. This alleviates the need to have additional components act as a magnetic shield outside the superconducting magnet, and brings forth the effect that the device can be rendered small in size and low in cost.

0189970

CLAIMS:

1.  A superconducting magnet which comprises:

a superconducting coil (4) which generates a magnetic field when current is caused to flow therethrough;  and

a vacuum heat insulation vessel (6) which serves to receive the coil and to hold it at a cryogenic temperature;

characterised in that said vacuum heat insulation vessel (6) has a part thereof made of a ferromagnetic material which has a size and a thickness sufficient to exhibit a magnetic shield effect.

2.  A superconducting magnet as defined in claim 1, characterised in that an outer cylinder portion (7) of said vacuum heat insulation vessel (6) is made of the ferromagnetic material thick enough to exhibit the magnetic shield effect.

3.  A superconducting magnet as defined in claim 1, charaterised in that an outer cylinder portion (7) of said vacuum heat insulation vessel (6) and both end flange portions (9a) continuous to said outer cylinder portion are made of the ferromagnetic material thick enough to exhibit the magnetic shield effect.

0189970

4.  A superconducting magnet as defined in claim 2 or 3 characterised  in that a protrusion (13a) which is provided in order to set a heat insulation distance of said outer cylinder portion (7) of said vacuum heat insulation vessel (6) is made of the ferromagnetic material thick enough to exhibit the magnetic shield effect.

5.  A superconducting magnet as claimed in claim 2, 3 or 4, characterised in that said superconducting coil is arranged concentrically with said outer cylinder.

# FIG. 1

# FIG. 2

# FIG. 3 PRIOR ART

# FIG. 4 PRIOR ART

European Patent
Office

**EUROPEAN SEARCH REPORT**

0189970
Application number

EP 86 30 0067

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| A | EP-A-0 111 218 (BRUKER ANALYTISCHE MESSTECHNIK) * Pages 7,8; page 9, first paragraph * | 1-5 | H 01 F 7/22 |
| A | FR-A-2 020 666 (THE BRITISH OXYGEN CO.) | | |
| A | US-A-4 484 814 (MITSUBISHI) | | |

TECHNICAL FIELDS
SEARCHED (Int. Cl 4)

H 01 F 7/00

The present search report has been drawn up for all claims

| Place of search | Date of completion of the search | Examiner |
|---|---|---|
| THE HAGUE | 14-04-1986 | VANHULLE R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82